# EUROPÄISCHE PATENTSCHRIFT

(11) **EP 0 684 697 B1**
(45) Veröffentlichungstag und Bekanntmachung des Hinweises auf die Patenterteilung: **08.04.1998**
(21) Anmeldenummer: 95106948.3
(22) Anmeldetag: 09.05.1995
(51) Int. Cl.: H03D 1/22

(54) **Empfänger für zweiseitenband-modulierte Signale**
Receiver for double sideband modulated signals
Récepteur de signaux modulés à double bande latérale

(30) Priorität: 28.05.1994 DE 4418692
(43) Veröffentlichungstag der Anmeldung: 29.11.1995
(73) Patentinhaber: ROBERT BOSCH GMBH, 70442 Stuttgart (DE)
(72) Erfinder: Becker, Joachim, Dr. Phys., D-71522 Backnang (DE)

(56) Entgegenhaltungen:
- DE-A- 2 746 979
- GB-A- 2 215 930

## Beschreibung

Die vorliegende Erfindung betrifft einen Emfpänger für zweiseitenband-modulierte Signale mit einem oder mehreren modulierten Unterträgern.

Ein Empfänger für zweiseitenband-amplitudenmoduliete Signale ist z.B. aus der DE 27 46 979 C2 bekannt. Es handelt sich dabei um einen an sich bekannten Quadraturempfänger, der zwei mit einer Phasendifferenz von 90° betriebene Synchrondemodulatoren aufweist. Bei diesem Empfängerprinzip wird jedem Demodulator ein Teil des Empfangssignals mit seinen zwei Seitenbändern zugeführt.

Aus der GB-A-2 215 930 ist eine Empfängerschaltung bekannt für ein Signal mit mehreren Unterträgern, von dem jeder zwei Seitenbänder aufweist. Die oberen und die unteren Seitenbänder aller Unterträger werden in der Empfängerschaltung voneinander getrennt. Dann werden die unteren Seitenbänder aller Unterträger und die oberen Seitenbänder aller Unterträger für sich detektiert. Anschließend werden die detektierten unteren Seitenbänder und die detektierten oberen Seitenbänder aller Unterträger getennt voneinander aufaddiert. Das Signal-zu-Rausch-Verhältnis des Empfangssignals soll gemäß diesem Stand der Technik dadurch verbessert werden, daß mittels Filtern die Bandbreite der Seitenbänder reduziert wird.

Z.B. in der Verkehrsleittechnik oder bei der Identifizierung von Personen, Fahrzeugen oder dgl. findet ein Datenaustausch zwischen Funkeinrichtungen statt, deren relative Lage zueinander unbekannt ist und sich im allgemeinen ändert. Verwendet man zur Übertragung der Daten zweiseitenband-modulierte Signale, so ist die relative Phasenlage zwischen den beiden Seitenbändern unbekannt bzw. variiert ebenfalls. Bei üblichen Zweiseitenbandempfängern führt das dazu, daß im demodulierten Empfänger-Ausgangssignal Auslöschungen auftreten. Dieses Problem könnte durch Einsatz eines Einseitenbandempfängers umgangen werden. Er empfängt eines der beiden Seitenbänder und unterdrückt das andere. Die Signalleistung in einer Hälfte des empfangenen Nutzspektrums wird unberücksichtigt gelassen und folglich sowohl ein schlechtes Signal-zu-Rausch-Verhältnis wie auch ein schlechtes Signal-zu-Störung-Verhältnis erzielt.

Der Erfindung liegt nun die Aufgabe zugrunde, einen Empfänger der eingangs genannten Art anzugeben, der zweiseitenband-modulierte Signale mit einem möglichst hohen Signal-zu-Rausch- und großen Signal-zu-Störungs-Verhältnis empfängt.

Erfindungsgemäß wird diese Aufgabe durch die Merkmale des Anspruchs 1 gelöst. Zweckmäßige Ausbildungen der Erfindung gehen aus den Unteransprüchen hervor.

Dadurch, daß nach der Erfindung die Signalleistung beider Seitenbänder ausgenutzt wird, verbessert sich das Signal-zu-Rausch-Verhältnis. Und aufgrund der getrennten Verarbeitung der beiden Seitenbänder können statische oder zeitlich veränderliche Phasenablagen zwischen ihnen nicht zu Auslöschungen des Empfangssignals führen. Bei schmalbandigen Störsignalen ist nur ein Seitenband betroffen, daher wirken sie sich weniger als bei einem Einseitenband-Empfänger aus.

Anhand einiger in der Zeichnung dargestellter Ausführungsbeispiele wird nachfolgend die Erfindung näher erläutert. Es zeigen:
Fig. 1 eine prinzipielle Schaltung eines Zweiseitenband-Empfängers,
Fig. 2 einen Zweiseitenband-Empfänger mit einem Einseitenbandmischer,
Fig. 3 einen Zweiseitenband-Empfänger mit zwei Einseitenbandmischern und
Fig. 4 einen Zweiseitenband-Empfänger für zweiseitenbandmodulierte Signale mit mehreren Unterträgern.

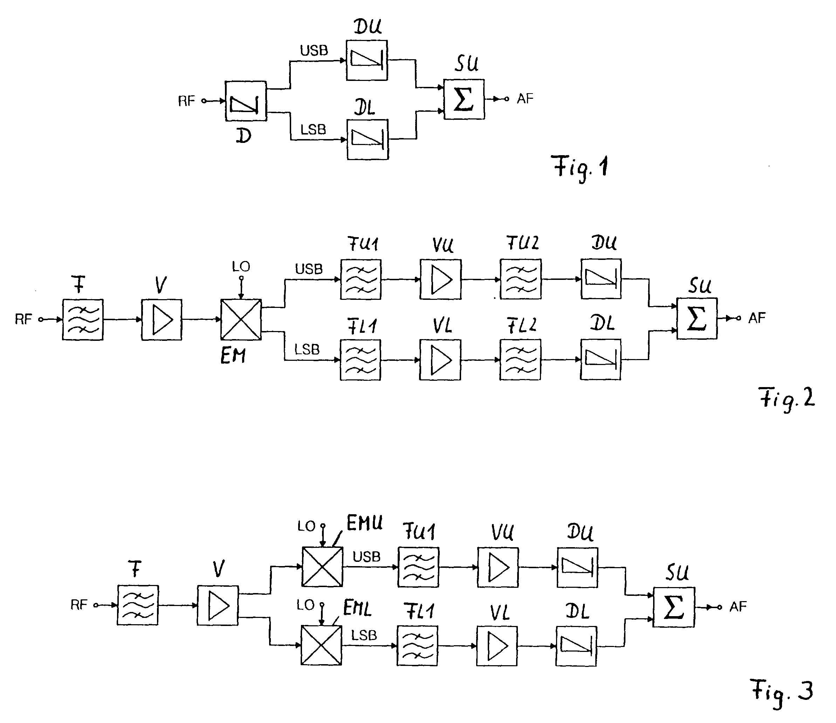

Der in Fig. 1 dargestellte Empfänger dient dazu, ein zweiseitenband-moduliertes Empfangssignal RF, das einen mit einem Datensignal modulierten Unterträger aufweist, zu demodulieren. Der Empfänger weist einen ersten Demodulator D auf, der das zweiseitenband-modulierte Empfangssignal RF in das obere USB und das untere Seitenband LSB zerlegt. Beide Seitenbänder USB und LSB enthalten den modulierten Unterträger. Für jedes der voneinander getrennten Seitenbänder USB, LSB ist ein eigener Demodulator DU, DL vorgesehen, der den modulierten Unterträger demoduliert. Für den Unterträger kann jedes beliebige Modulationsverfahren angewendet werden. Dementsprechend sind auch die Demodulatoren DU, DL zu wählen. Nach der getrennten Demodulation sind die Signale der beiden parallelen Signalwege von den relativen Phasenlagen der Seitenbänder im Eingangssignal RF unabhängig, und die demodulierten Signale können in einer Summierschaltung SU addiert werden, ohne daß es zu einer gegenseitigen teilweisen oder vollständigen Auslöschung kommt. Das Ausgangssignal AF der Summierschaltung SU setzt sich also aus den Signalleistungen beider Seitenbänder USB und LSB zusammen, wodurch das Signal-zu-Rausch-Verhältnis des Ausgangssignals AF möglichst groß ist.

Zur Realisierung des ersten Demodulators D, welcher die beiden Seitenbänder USB und LSB getrennt voneinander gewinnt, gibt es mehrere Varianten. Zwei davon gehen aus den Figuren 2 und 3 hervor. Bei den in Fig. 2 und 3 dargestellten Schaltungsvarianten wird davon ausgegangen, daß das Empfangssignal RF zweiseitenband-amplitudenmoduliert oder zweiseitenband-amplitudenumgetastet (ASK) ist. Dementsprechend wird gemäß Fig. 2 als Demodulator ein Einseitenbandmischer EM verwendet, der die beiden Seitenbänder USB und LSB an getrennten Ausgängen zur Verfügung stellt. Dem Einseitenbandmischer EM ist in bekannter Weise ein Oszillatorsignal LO mit der dem Eingangssignal entsprechenden Trägerfrequenz zugeführt.

Oszillatorfrequenz und Trägerfrequenz müssen nicht genau übereinstimmen, eine geringe Differenzfrequenz (z.B. durch Ungenauigkeit des Oszillators oder den Dopplereffekt) wirkt sich nicht nachteilig aus. Beim Ausführungsbeispiel gemäß Figur 3 wird das Eingangssignal RF auf zwei Einseitenbandmischer EMU und EML aufgeteilt, dabei gewinnt der Mischer EMU nur das obere Seitenband USB und der Mischer EML nur das untere Seitenband LSB.

Abweichend von den beschriebenen Ausführungsbeispielen kann der Empfänger auch für Empfangssignale RF angelegt sein, die nach anderen Zweiseitenband-Modulationsverfahren moduliert sind (z.B. PSK).

Um eine möglichst störungsarme Signalverarbeitung des Empfängers zu gewährleisten, können, wie die Figuren 2 und 3 verdeutlichen, Filter und Verstärker vorgesehen werden, z.B. ein Filter F und ein Verstärker V am Eingang der Schaltung und weitere Filter FU1, FU2; FL1, FL2 und Verstärker VU, VL in den einzelnen Seitenbändern zugeordneten Signalzweigen. Die Signalverarbeitung (Filterung, Demodulation, Summation) kann in bekannter Weise analog und/oder digital erfolgen.

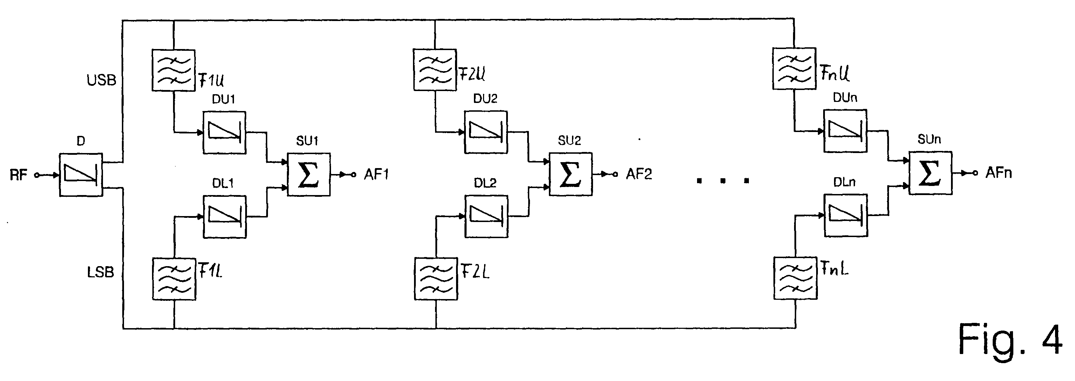

Die Fig. 4 zeigt einen Empfänger für ein zweiseitenband-moduliertes Signal RF mit mehreren modulierten Unterträgern, die unterschiedlichen Frequenzen zugeordnet sind. Nachdem der erste Demodulator D die Seitenbänder USB, LSB voneinander getrennt hat, werden diese über Filter F1U, F1L, F2U, F2L, ... FnU, FnL frequenzmäßig auf die einzelnen Unterträger aufgeteilt. Für jeden Unterträger gibt es, wie oben schon dargelegt, zwei Demodulatoren DU1, DL1; DU2, DL2; ... DUn, DLn und eine die Ausgangssignale der Demodulatoren addierende Summierschaltung SU1, SU2, ... SUn.

## Patentansprüche

1. Empfänger für zweiseitenband-modulierte Signale mit einem oder mehreren modulierten Unterträgern,
wobei ein erster Demodulator (D, EM, EMU, EML) vorgesehen ist, der das empfangene Signal (RF) in zwei Seitenbänder (USB, LSB) zerlegt, von denen jedes den oder die modulierten Unterträger enthält und wobei für jedes Seitenband und jeden darin enthaltenen modulierten Unterträger ein eigener zweiter Demodulator (DU, DL, DU1, DL1, DU2, DL2, ... DUn, DLn) vorgesehen ist, dadurch gekennzeichnet, daß für jeden Unterträger eine Summierschaltung (SU, SU1, SU2, ... SUn) vorhanden ist, welche die Ausgangssignale der dem jeweiligen Unterträger zugeordneten zweiten Demodulatoren (DU, DL, DU1, DL1, DU2, DL2, ... DUn, DLn) addiert.

2. Empfänger nach Anspruch 1, dadurch gekennzeichnet, daß der erste Demodulator aus zwei Einseitenbandmischern (EMU, EML) besteht, von denen der eine nur das obere Seitenband (USB) und der andere nur das untere Seitenband (LSB) detektiert.

3. Empfänger nach Anspruch 1, dadurch gekennzeichnet, daß der erste Demodulator aus einem Einseitenbandmischer (EM) besteht, der an zwei Ausgängen die beiden Seitenbänder (USB, LSB) getrennt zur Verfügung stellt.

## Claims

1. Receiver for double sideband-modulated signals with one or more modulated subcarriers, a first demodulator (D, EM, EMU, EML) being provided which decomposes the received signal RF into two sidebands (USB, LSB), each of which contains the modulated subcarrier or subcarriers, and, for each sideband and each modulated subcarrier contained therein, a single second demodulator (DU, DL, DU1, DL1, DU2, DL2, ... DUn, DLn) being provided, characterized in that, for each subcarrier, there is an adder circuit (SU, SU1, SU2, ... SUn) which adds the output signals of the second demodulators (DU, DL, DU1, DL1, DU2, DL2, ... DUn, DLn) assigned to the respective subcarrier.

2. Receiver according to Claim 1, characterized in that the first demodulator consists of two single-sideband mixers (EMU, EML), of which one detects only the upper sideband (USB) and the other detects only the lower sideband (LSB).

3. Receiver according to Claim 1, characterized in that the first demodulator consists of a single-sideband mixer (EM) which makes the two sidebands (USB, LSB) available separately at two outputs.

## Revendications

1. Récepteur pour des signaux modulés à bande latérale double comprenant une ou plusieurs sous-porteuses modulées, dans lequel
- un premier démodulateur (D, EM, EMU, EML) décompose le signal reçu (RF) en deux bandes latérales (USB, LSB) dont chacune contient la ou les sous-porteuses modulées et
- pour chaque bande latérale et chaque sous-porteuse modulées qu'elle contient, il est prévu un second démodulateur propre (DU, DL, DU1, DL1, DU2, DL2, ... DUn, Dln),
caractérisé par
un circuit additionneur (SU, SU1, SU2, ... SUn) pour chaque sous-porteuse qui additionne les signaux de sortie des seconds démodulateurs (DU, DL, DU1, DL1, DU2, DL2, ... DUn, DLn) associés à chaque sous-porteuse.

2. Récepteur selon la revendication 1,
caractérisé en ce que
le premier démodulateur se compose de deux mélangeurs de bande latérale unique (EMU, EML) dont l'un détecte seulement la bande latérale supérieure (USB) et l'autre seulement la bande latérale inférieure (LSB).

3. Récepteur selon la revendication 1,
caractérisé en ce que
le premier démodulateur se compose d'un mélangeur de bande latérale unique (EM) qui fournit de manière séparée les deux bandes latérales (USB, LSB) à deux sorties.
